# DEMANDE DE BREVET EUROPEEN

(11) **EP 3 557 438 A2**
(43) Date de publication de la demande: **23.10.2019**
(21) Numéro de dépôt: 19170201.8
(22) Date de dépôt: 18.04.2019
(51) Int. Cl.: G06F 16/29

(54) **PLATEFORME INFORMATIQUE POUR L'AGREGATION ET LA VISUALISATION DE DONNEES NUMERIQUES**

(30) Priorité: 19.04.2018 FR 1853443
(71) Demandeur: Soletanche Freyssinet, 92500 Rueil-Malmaison (FR)
(72) Inventeur: MARTINET, Jacques, 91430 Igny (FR)
(74) Mandataire: Nony

(57) **Abrégé**

Plateforme informatique (1) pour l'agrégation et la visualisation de données numériques à l'échelle planétaire ou sub-planétaire, dans laquelle sont répertoriées des données géoréférencées servant à la représentation d'objets hétérogènes provenant de sources différentes, dont des objets issus de scans et des objets issus d'au moins un logiciel de dessin assisté par ordinateur, à au moins une partie des données géo-référencées étant associées des métadonnées enregistrées dans au moins une base de données, ces métadonnées comportant au moins une information relative à la précision avec laquelle la position dans au moins un référentiel de ces données géo-référencées est connue.

## Description

La présente invention concerne la réalisation d'ouvrages, notamment de bâtiments ou d'infrastructures souterraines ou de surface, et les moyens mis à la disposition des professionnels du secteur pour les aider dans leurs travaux.

### Arrière-plan

Lorsque des travaux tels que la réalisation d'une excavation doivent être réalisés à proximité de réseaux enterrés, il est habituel de requérir une autorisation administrative (DT-DICT) auprès des services d'urbanisme de la mairie concernée. Ces derniers interrogent un certain nombre de sociétés ou organismes pour que ceux-ci déclarent si des canalisations ou autres éléments enterrés sont présents dans la zone considérée, et dans l'affirmative connaître leur position.

Dans la pratique, ces démarches prennent du temps et la précision de l'information de localisation des réseaux enterrés est parfois très approximative, entraînant un risque lors du creusement. Pour réduire ce risque, des forages ou sondages préliminaires sont réalisés, ce qui entraîne toutefois un surcoût et ralentit le chantier.

On connaît des sites en ligne tels que celui de l'IGN ou de la BRGM qui permettent de visualiser des cartes relatives à l'occupation des sols ou à la nature géologique du sous-sol. Toutefois, les cartes produites ne concernent pas le détail des infrastructures existantes et ne donnent pas en ce qui concerne la géologie une information ayant la précision requise pour la réalisation de travaux.

Le brevet US 8 799 799 décrit une carte interactive qui n'est toutefois pas prévue pour aider à la réalisation de travaux dans le sous-sol.

Il existe des maquettes à l'échelle urbaine proposées sous le standard CityGML De telles maquettes n'abordent toutefois pas la problématique du repérage des réseaux enterrés.

Il existe par ailleurs des modèles 3D de terrassement par ordinateur, dans lequel un conducteur d'engin est guidé par son ordinateur de bord qui compare la position de l'engin à celle du modèle 3D du terrassement à réaliser pour fournir les consignes adaptées.

Il a été proposé dans l'ouvrage BIM & BTP Editions Méthodes BTP 2017 d'intégrer dans une maquette numérique urbaine la position de chaque réseau, ce qui permettrait de signaler au conducteur d'un engin la proximité d'un réseau. Toutefois, comme le souligne l'auteur, le problème provient essentiellement du manque de fiabilité des DOE (Dossiers d'Ouvrages Exécutés) rencontré dans la pratique, que ne peut résoudre pas à elle seule une telle maquette.

Il existe par conséquent un besoin pour réduire le risque d'endommagement de canalisations ou autres éléments enterrés lors de la réalisation de travaux d'excavation.

Il existe de nombreuses autres situations où la connaissance avec précision de l'état du sous-sol permettrait de réduire le coût et la durée des chantiers.

Il existe par conséquent un besoin pour faciliter la réalisation d'ouvrages ou l'intervention sur des sites où sont potentiellement présents des réseaux enterrés.

Il demeure plus généralement un besoin pour améliorer les échanges et partages de données entre professionnels de la construction, et fiabiliser les données relatives aux ouvrages construits et interventions réalisées.

Il y a également un intérêt à créer de nouveaux outils pour prédire l'évolution d'ouvrages en fonction de divers facteurs, notamment leur vieillissement, et faciliter leur maintenance ou exploitation.

### Résumé

L'invention vise à répondre à tout ou partie de ces objectifs, et elle y parvient grâce à une plateforme informatique pour l'agrégation et la visualisation de données numériques à l'échelle planétaire ou sub-planétaire, dans laquelle sont répertoriées des données géo-référencées servant à la représentation d'objets hétérogènes provenant de sources différentes, dont des objets issus de scans et des objets issus d'au moins un logiciel de dessin assisté par ordinateur, à au moins une partie des données géo-référencées étant associées des métadonnées enregistrées dans au moins une base de données, ces métadonnées comportant au moins une information relative à la précision avec laquelle la position dans au moins un référentiel de ces données géoréférencées est connue.

Ce référentiel peut être un référentiel absolu, ou relatif.

Par « à l'échelle planétaire ou sub-planétaire » il faut comprendre que la plateforme permet d'agréger et de visualiser des données dont la localisation peut être quelconque sur la planète ou sur un territoire étendu de celle-ci, par exemple un continent, un pays, une région, ou une ville. La plateforme n'est ainsi pas limitée à l'agrégation et la visualisation de données cantonnées à un bâtiment ou à un seul chantier localisé. Les données agrégées peuvent concerner des sites éloignés de plus de 100 km par exemple.

Par « objet issu de scan » il faut comprendre un objet construit ou modélisé à partir d'acquisitions réelles, par exemple à partir d'acquisition de la géométrie d'un bâtiment, terrain, infrastructure terrestre ou souterraine, équipement. L'acquisition de la géométrie peut être doublée d'une acquisition de la texture. Pour réaliser le scan, on peut utiliser toute technique d'acquisition optique ou électromagnétique adapté, par exemple scan laser, notamment de type lidar, acquisition photogrammétrique, radargrammétrique, etc...

Par « objet issu d'au moins un logiciel de dessin assisté par ordinateur » il faut comprendre un fichier généré par un logiciel de conception assistée par ordinateur, permettant une représentation de l'objet, notamment 3D. Il peut s'agir de tout fichier généré avec un logiciel métier tel qu'utilisé par les architectes ou les ingénieurs de génie civil ou les topographes, par exemple du type AutoCad ou AutoDesk.

L'invention présente de nombreux avantages.

Elle permet tout d'abord de centraliser l'information relative à l'occupation du sol et du sous-sol, ce qui facilite l'accès aux données pertinentes pour préparer une intervention par exemple, et permet des échanges montants et descendants d'informations entre une grande diversité d'utilisateurs de la plateforme. La plateforme peut être agencée pour permettre d'afficher sur une carte par exemple des données d'ouvrages ou de chantier, le tout avec une précision compatible avec des travaux à réaliser, par exemple de visualiser l'implantation des fondations, les réseaux tels que construits, les tranchées, les résultats de sondages géologiques, cette liste n'étant pas limitative.

La durée du chantier s'en trouve raccourcie et les risques de percer une canalisation ou de toucher un câble électrique enterré s'en trouvent réduits.

De plus, la plateforme est enrichie en permanence par les données entrées par les utilisateurs intervenant sur un site, et il est ainsi possible de connaître de mieux en mieux la position et la nature des réseaux enterrés au fur et à mesure des interventions.

La plateforme peut également comporter des outils qui extraient de façon automatique des informations pertinentes pour la localisation des réseaux enterrés à partir des données téléchargées par les divers intervenants sur un site, comme expliqué plus loin, ce qui permet d'enrichir de métadonnées la plateforme, et rendre celle-ci de plus en plus complète au cours du temps.

Par « utilisateur » on désigne un client (au sens informatique) de la plateforme, qui se connecte à celle-ci par un terminal qui peut être de tout type. Les données géo-localisées précitées peuvent comporter des données liées à la conception, la construction et/ou l'exploitation d'un bâtiment ou d'une infrastructure de surface ou souterraine. Les données géolocalisées peuvent couvrir l'ensemble d'un territoire national ou régional, et comporter des données correspondant à des chantiers, ouvrages ou équipements respectifs éloignés de plus de 100 km, comme mentionné plus haut. La plateforme numérique permet d'englober plus qu'une maquette numérique urbaine, et offre des possibilités accrues permettant de lutter contre le manque de fiabilité rencontré jusqu'à présent sur de nombreux sites.

Selon une mise en oeuvre préférée de l'invention, la plateforme est agencée pour permettre à une pluralité d'utilisateurs de se connecter à distance via des terminaux à celle-ci et pour permettre de réserver l'accès à certaines données à un groupe d'utilisateurs prédéfini, ce mode de fonctionnement étant dit « mode fermé », ou au contraire de mettre ces données à disposition de tous les utilisateurs, ce mode de fonctionnement étant qualifié de « mode ouvert ».

Les données peuvent être des données relatives au sous-sol et/ou à des objets incorporés dans le sol Celles-ci peuvent correspondre à des données acquises lors de compagnes de mesures sur le terrain ou lors de forages, ou à des données « interprétées » c'est-à-dire estimées à partir de modèles théoriques.

Ces données peuvent être issues d'essais géotechniques, de mesures piézométriques, d'analyses hydro-chimiques *in situ* et/ ou en laboratoire. Par exemple, ces données peuvent être relatives aux caractéristiques mécaniques hydriques et/ ou hydrauliques du sol, comme la résistance à la compression et/ou au cisaillement, la teneur en eau, le degré de saturation ou la perméabilité, des données relatives aux caractéristiques géothermiques du sol ou encore à la granularité de celui-ci.

En outre, les données peuvent comporter des données fournissant des informations sur des réserves de matières utiles:minerais, charbon, eau, hydrocarbures, matériaux de carrières ou granulats, entre autres.

Les données peuvent également comporter des données relatives à des installations souterraines, par exemple une galerie, un tunnel, un réseau de conduites de gaz, d'électricité, de fibres optiques, de télécommunications, de canalisations de chauffage urbain, d'eau potable ou d'assainissement.

Les données enregistrées dans la base de données peuvent comporter des photographies, par exemple des images panoramiques, des orthophotographies, notamment des images aériennes et satellitaires ou encore des images de type élévation.

Les données enregistrées dans la base de données peuvent également comporter des données issues de scan laser, notamment sous forme de nuages de points.

Une modélisation des objets de la plateforme peut ainsi être obtenue en utilisant des techniques telles que par exemple la lasergrammétrie, la photogrammétrie, l'interférométrie ou encore les techniques de dessin assisté par ordinateur (DAO).

La plateforme est avantageusement agencée pour permettre à un utilisateur de sélectionner un objet, notamment un lieu, ouvrage et/ou équipement pour accéder à et/ou télécharger des données géolocalisées relatives à celui-ci, ces données étant délivrées par la plateforme avec une information relative à la précision avec laquelle la position de ces données géolocalisées est connue, notamment dans un référentiel.

Ainsi, un nouvel utilisateur de la plateforme dispose d'une information sur la précision de l'information de géolocalisation donnée par un utilisateur précédent de la plateforme, et peut adapter les travaux en conséquence. Par exemple, le nombre et la position des forages préliminaires peut être adaptée en fonction de la précision de l'information. Plus l'information est précise, plus le nombre de forages préliminaires ou de sondages radar peut être réduit.

Il est possible de certifier si on le souhaite la précision de certaines données en ce qui concerne leur géolocalisation, en procédant par exemple à une vérification sur site ultérieurement, ou en imposant le respect d'une procédure particulière pour la fourniture d'une information de géolocalisation par un utilisateur. Cette information peut être certifiée par une blockchain par exemple.

Il est possible de générer un indice de confiance concernant la précision de localisation déclarée pour certaines données. En présence d'un indice de confiance élevé, la réalisation de forages ou sondages préliminaires peut être évitée ou limitée.

La plateforme peut comporter des données géologiques du sous-sol ayant une précision de géolocalisation, dans un référentiel, meilleure que 1m et/ou être agencée pour permettre l'enregistrement sur la plateforme de telles données.

Ainsi, lorsque des carottages ou forages sont réalisés, la précision de localisation de l'outil étant connue dans un référentiel, les données résultant de ces carottages ou forages peuvent être facilement répertoriées dans la plateforme, et servir ultérieurement à d'autres utilisateurs pour connaître la nature précise du sous-sol en un endroit.

Pour faciliter l'entrée d'informations, la plateforme est avantageusement agencée pour permettre à un utilisateur d'attacher des documents à un objet, notamment un lieu, ouvrage, équipement ou autre objet répertorié par la plateforme, par exemple présent sur une carte affichée sur le terminal de l'utilisateur. Par exemple, à chaque objet affiché sur la carte, des documents peuvent être attachés, par exemple des photographies, visualisables directement ou à travers une application tierce. Il est possible de rattacher à un objet des paramètres de souscription, des actions en cours et à venir sur cet objet et des informations temporelles, par exemple une date de création, de mise à jour ou autre, ainsi qu'un historique des modifications. Le fait d'attacher des photographies peut présenter des avantages en termes de simplicité pour l'utilisateur, qui peut ainsi facilement enrichir la base, et de possibilités de traitement par la suite, grâce à une analyse automatique d'image par exemple pour reconnaître des équipements et les dénombrer ou effectuer des mesures ou déterminer leur état ou emplacement précis, lorsqu'un point de référence géo-localisé sur la photographie le permet.

La plateforme peut être agencée pour offrir tout ou partie des fonctionnalités suivantes :
- permettre à un utilisateur de téléverser une application pour la mettre à disposition d'autres utilisateurs de la plateforme et leur permettre de l'exécuter au sein de la plateforme pour traiter leurs données ; par exemple, un utilisateur peut téléverser sur la plateforme une application que d'autres utilisateurs peuvent exécuter lorsqu'ils se connectent à celle-ci pour traiter leurs données, par exemple produire des statistiques, prédire le vieillissement d'un ouvrage à partir d'un certain nombres de paramètres relevés sur le terrain et/ou historiques ;
- permettre à un utilisateur de partager une information avec d'autres utilisateurs de la plateforme et/ou permettre à au moins deux utilisateurs de travailler en collaboration à travers la plateforme par échanges de données entre ces utilisateurs ou via des accès multiples à une information ; cela peut faciliter la transmission d'informations entre différents intervenants sur un même chantier, appartenant à divers corps de métier, et réduire les risques d'erreurs ou faciliter le planning des interventions ; par exemple un utilisateur peut téléverser des photographies qui pourront être visualisés par d'autres utilisateurs, notamment appartenant à un groupe d'utilisateurs autorisés à accéder à ces données ;
- permettre à un utilisateur d'enregistrer directement ses données et/ou de les télécharger depuis une base de données tierce ; par exemple, un utilisateur peut enregistrer sur la plateforme un scan d'un ouvrage tel que construit, ou enregistrer ses données présente sur un site hébergeant une maquette numérique, vers la plateforme ;
- permettre à un utilisateur de créer un profil personnalisé d'utilisateur et d'interagir avec la plateforme via une interface personnalisée ; par exemple, un géomaticien pourra créer un profil « métier » différent de celui d'un architecte ou d'un responsable de chantier ; la possibilité de créer un profil spécifique peut permettre aux utilisateurs d'accéder plus rapidement à l'information pertinente ;
- permettre à un utilisateur d'enregistrer dans la plateforme des données relatives à différents objets, notamment ouvrages et/ou équipements tels que construits, au moins une partie de ces données étant des données géolocalisées dans un référentiel;
- permettre à un utilisateur d'enrichir les données d'ouvrages et/ou d'équipements répertoriés dans la plateforme par des métadonnées choisies notamment parmi le nom de l'ouvrage ou de l'équipement, une caractéristique de l'ouvrage, une date, notamment de construction, et pour permettre à un utilisateur de faire des recherches multicritères sur ces éléments ;
- permettre à un utilisateur ayant réalisé une intervention dans un lieu ou sur un ouvrage et/ou équipement répertorié dans la plateforme, d'enregistrer sur celle-ci un score représentatif de la fiabilité des données renseignées, notamment de la fiabilité de l'information de précision de localisation des données géolocalisées, un indice de confiance étant de préférence calculé à partir des scores renseignés par les utilisateurs précédents et fourni à chaque nouvel utilisateur cherchant à télécharger ces données ;
- permettre à un utilisateur se connectant à la plateforme d'interroger celle-ci concernant l'évolution d'au moins un paramètre d'un ouvrage et/ou d'un équipement, et d'obtenir en retour, grâce à un outil de prédiction, une prévision sur le devenir dudit paramètre, l'outil de prédiction ayant été généré en traitant des données enregistrées sur la plateforme à l'aide d'un moteur à intelligence artificielle ou par une technique d'analyse statistique ; par exemple, la masse des données présentes sur la plateforme relative à un paramètre représentatif par exemple à un percement de la nappe phréatique est analysée pour rechercher les meilleurs indices révélateur d'un tel percement, ce qui permet ensuite de réagir plus rapidement face à un tel risque en prenant les actions qui s'imposent ; des données relatives au vieillissement d'ouvrages en fonction des matériaux utilisés, des techniques de construction mises en oeuvre, des conditions de l'environnement et d'exploitation de l'ouvrage, par exemple du trafic enregistré, peuvent être analysées pour générer un modèle prédictif du vieillissement de l'ouvrage en fonction de certains paramètres, et ainsi adapter la maintenance en conséquence ;
- fournir des informations permettant de guider un engin ou d'assister un opérateur grâce à de la réalité augmentée.

Les données géolocalisées enregistrées dans la plateforme peuvent comporter des données liées à la conception, la construction et/ou l'exploitation d'un bâtiment ou d'une infrastructure de surface ou souterraine, tel qu'existant.

La plateforme peut être agencée pour exécuter une application pour analyser la corrélation entre au moins deux modèles 3D relatifs à un même ouvrage ou équipement et générer en fonction des corrélations détectées un nouveau modèle 3D à partir de la fusion des deux modèles analysés. Ce peut améliorer l'utilisation de la plateforme, en réduisant le nombre de fichiers au profit d'un accès plus facile à l'information recherchée.

La plateforme peut recevoir, notamment en temps réel, des données de capteurs ou des données météorologiques, thermiques, satellites, notamment sur le relief d'un terrain, de trafic et/ou sismiques, et permettre à au moins un utilisateur d'accéder à et/ou de télécharger ces données. Ces données peuvent utilement alimenter des moteurs d'analyse prédictive, en vue d'aider à prédire certains phénomènes. Les données peuvent provenir de capteurs installés sur les infrastructures ou le sol de type très divers, permettant par exemple de surveiller la pression, l'écartement, les vibrations, la piézométrie, l'inclinaison, ces capteurs étant par exemple utilisés en phase de construction d'un tunnel pour surveiller qu'il ne se passe rien en surface. Il peut s'agir également de capteurs fournissant des données d'environnement pour une phase de gestion d'infrastructure, par exemple une mesure d'un taux d'utilisation. Il peut s'agir encore de détecter le vieillissement d'une infrastructure et d'optimiser sa réparation et son coût total de possession, afin par exemple de savoir quand intervenir et planifier des réparations, de chaussés par exemple ou autres infrastructures. La réception de données en temps réel permet de fluidifier la communication, de limiter les pertes d'information, de réduire l'utilisation d'information obsolète, la durée des projets et de mieux contrôler les risques d'accidents. Cela peut également permettre de produire des statistiques fiables sur les chantiers pour réduire les risques d'accident.

La plateforme peut avantageusement exécuter une application pour convertir automatiquement un format dans lequel un fichier a été téléchargé en un format prédéfini et afficher sur une même carte des informations provenant de fichiers différents dont l'un au moins a subi cette conversion. Ainsi, l'utilisateur est déchargé des opérations de conversion, et les données peuvent être plus facilement utilisées par la plateforme. Le format des données enregistrés dans la plateforme est par exemple un format ouvert ou propriétaire, par exemple choisi parmi DWG, Ascii, OBJ, vectoriel, CVS, LAS ou open source tel que IFC.

La plateforme peut comporter :
- Une couche de stockage de données permettant de stocker des données, notamment des données géolocalisées, transmises par des utilisateurs à la plateforme,
- une couche de gestion de données permettant de contrôler l'accès à la plateforme, d'indexer les données, d'exporter ou d'importer les données,
- une couche de macro-fonctions fournies aux utilisateurs,
- une couche d'interface vers les utilisateurs.

La couche de stockage des données peut comporter :
- Un lac de données,
- une base de données relationnelle, comprenant de préférence toutes les informations structurées de la plateforme, et notamment les métadonnées permettant l'accès aux informations stockées dans la couche de données, notamment des données d'indexation de faits telles que des coordonnées spatio-temporelles, des groupements de faits, des hiérarchies, des mots clés, ainsi que la gestion de droits d'accès aux faits,
- une base de données, de préférence de type noSQL, pour le stockage de données non structurées, notamment de données provenant de capteurs,
- un espace de stockage, de préférence de type serveur de fichier, pour recevoir des fichiers associés aux faits, et
- un espace de gestion documentaire, de préférence de type gestion électronique de documents, fournissant un espace de partage et d'échange d'information aux utilisateurs.

La couche de gestion des données peut être accessible à la couche de macro-fonctions au travers d'une API, ce qui facilite la création d'un catalogue d'applications géré dans un magasin, par exemple de type « Playstore ». Les API permettent aux utilisateurs de créer des applications qui traitent leurs données.

La plateforme peut être configurée pour offrir tout ou partie des fonctionnalités suivantes :
- Un service d'accès multicritère, de recherche et d'accès en lecture aux faits,
- Un service de contrôle d'accès aux faits, permettant de garantir la sécurité des données.
- Un service d'extraction et d'export de faits, vers différents formats
- Un service de comptabilisation des accès, pour mesurer le taux d'utilisation des API et des différents types de données,
- Un service d'import et de mise à jour de manière massive ou unitaire, permettant d'enrichir, de traduire les formats, de filtrer, de hiérarchiser, de valider et de nettoyer les données lors de l'import,
- Un service de transformation de données configuré pour homogénéiser l'indexation des données, notamment en matière de référencement géospatial, pour corréler des données répondant à certains critères, notamment de proximité géographique, pour nettoyer et/ou enrichir certaines données externes ; cela permet à la plateforme de gérer rapidement les changements de repère, de manière fluide. Ceci est avantageux dans la mesure où il existe dans le monde des dizaines de repères officiels, et des milliers de repères privés ; par exemple, pour une mine à ciel ouvert, tous les capteurs et les points satellite sont dans un repère local à la mine ; on peut référencer certains objets automatiquement en fonction d'une finalité, par exemple rechercher tous taux les compteurs d'eau d'un quartier pour en faire le relevé.

La couche de macro-fonctions peut être agencée pour réaliser tout ou partie des fonctions suivantes, et de préférence l'intégralité des fonctions suivantes :
- Création et gestion d'un compte utilisateur sur la plateforme,
- naviguer dans les faits renseignés sur la plateforme à l'aide d'un navigateur,
- l'accès à des données de la plateforme depuis des applications externes à celle-ci, et
- la gestion des sources de données.

Le navigateur peut être agencé pour offrir tout ou partir des fonctionnalités suivantes :
- permettre une visualisation cartographique, de préférence de type GIS, avec un rendu 2D, 2,5D ou 3D en fonction du niveau de zoom, le navigateur étant de préférence agencé pour permettre l'affichage d'un catalogue de fonds de cartes disponibles et la sélection d'un ou plusieurs fonds de carte, et l'affichage en superposition d'au moins une partie des informations des fonds de carte sélectionnés, et notamment permettre de changer l'ordre de superposition des fonds de carte au sein de la carte affichée et/ou d'implémenter des balises d'action ou d'information sur une carte ;
- permettre d'afficher le déploiement d'un polygone de sélection sur une carte et/ou étant agencé pour calculer la distance entre deux points ou objets, par exemple entre deux vannes raccordées par un tuyau ou la largeur d'une infrastructure, par exemple d'une route, la distance projetée, la surface d'une zone sélectionnée, la surface projetée, avec de préférence une possibilité de sélectionner la couleur et/ou la transparence de la zone sélectionnée et l'apparition de celle-ci en fonction du zoom ;
- permettre d'implémenter une barre graphe et des coupes longitudinales représentant une stratigraphie du sous-sol ;
- permettre d'affecter et d'afficher dans un format prédéfini un attribut à un objet figurant sur la carte ;
- permettre de créer un groupe d'objets et de le faire apparaître en tant que tel sur la carte ;
- permettre d'afficher automatiquement des grandeurs liées aux objets apparaissant sur la carte, notamment la surface des objets, le nombre d'objets par type, le nombre de documents liés ;
- permettre une recherche par coordonnées dans un référentiel;
- offrir des outils de mesure d'une distance sur la carte, d'une surface, d'éditer un profil altimétrique, de calculer une isochrone, de mesurer un azimut, et/ou de simuler un éclairage d'un site en fonction de l'heure dans la journée ;
- permettre de définir et de mémoriser un profil de recherche, notamment permettant d'afficher automatiquement des champs de recherche prédéfinis associés à un identifiant du utilisateur.

La couche d'interface vers les utilisateurs peut comporter l'un au moins :
- D'une interface de type Web,
- d'une interface de type application mobile,
- d'une interface de type passerelle d'API,
- d'une interface blockchain, notamment une interface comportant un noeud blockchain, de préférence de type Hyperledger (plateforme open source de développement de chaîne de blocs).

L'invention a encore pour objet un procédé d'enregistrement de données relatives à un chantier ou ouvrage, comportant l'étape consistant à réaliser au moins une acquisition optique géolocalisée, de préférence un scan géolocalisé, du chantier ou de l'ouvrage, et à téléverser dans la plateforme informatique selon l'invention cette acquisition, ainsi qu'une information de géoréférencement de l'acquisition dans un référentiel.

Le procédé peut comporter l'étape consistant à téléverser également dans la plateforme informatique une information relative à la précision avec laquelle l'information de géoréférencement est connue, l'acquisition étant notamment effectuée par télédétection par laser ou au moyen d'au moins une caméra. En variante, l'acquisition peut être effectuée par radar, par exemple un radargramme.

Le procédé peut comporter un traitement de l'acquisition par un outil de reconnaissance d'objets disponible sur la plateforme informatique et l'enrichissement de données relatives au chantier ou à l'ouvrage par des métadonnées issues de ce traitement. Par exemple, lorsque l'acquisition concerne un réseau enterré, l'outil de reconnaissance peut reconnaître automatiquement les conduites, vannes ou autres éléments du réseau et les répertorier. Cela peut permettre de comparer la réalité observée sur le terrain et la maquette numérique à partir de laquelle le réseau a été réalisé, et de mettre à jour la maquette numérique, pour faciliter les interventions ultérieures et bénéficier d'un retour d'expérience. L'outil de reconnaissance peut le cas échéant générer une représentation du réseau sous forme d'arcs et de noeuds.

L'invention a encore pour objet un procédé pour déterminer au moins un modèle prédictif de la survenance d'un événement, comportant un traitement statistique et/ou par intelligence artificielle de données enregistrées sur la plateforme selon l'invention, de façon à trouver un lien entre certains facteurs d'entrée et l'évènement et générer ledit modèle prédictif.

L'invention a encore pour objet un procédé de suivi de chantier, comportant l'étape consistant à équiper une zone d'au moins un instrument géolocalisé de suivi de chantier et à télécharger, notamment en temps réel, dans la plateforme informatique l'invention, des données issues de cet instrument.

Par « temps réel » au sens de l'invention, on désigne une mise à jour des données dans la plateforme effectuée avec une fréquence supérieure à une mise à jour toutes les heures, mieux toutes les 30 minutes, encore mieux toutes les 15 minutes.

L'invention a encore pour objet un procédé pour réaliser une intervention, notamment en sous-sol, comportant les étapes consistant à :
- Se connecter à la plateforme selon l'invention et télécharger des données géolocalisées relatives à un lieu et/ou ouvrage concerné par l'intervention,
- réaliser l'intervention en fonction de ces données, et de préférence publier sur le chantier un dossier d'intervention en ligne sur la plateforme.

L'intervention peut comporter le creusement d'une excavation et/ou la réalisation d'un forage.

L'intervention peut être réalisée en fonction de la précision avec laquelle la position dans un référentiel des données géolocalisées est connue, telle que fournie par la plateforme, permettant notamment de limiter le risque de toucher et dégrader un réseau enterré existant et ainsi de limiter le risque d'accident physique.

L'invention a encore pour objet un procédé de construction d'un ouvrage, notamment un bâtiment ou une infrastructure de surface ou souterraine, comportant les étapes consistant à :
- Télécharger et/ou visualiser, notamment dans un format prédéfini, à partir de la plateforme selon l'invention, des données géolocalisées relatives à l'environnement de l'ouvrage, notamment son sous-sol,
- réaliser l'ouvrage en tenant compte des données téléchargées et de leur mise à jour, notamment en temps réel, permettant de limiter les reprises de travaux, et de préférence en réalisant l'ouvrage de manière coordonnée en partageant entre les différents acteurs des informations relatives à des éléments d'infrastructure à caractère géographique telles que des informations concernant les réseaux ou bâtiments et/ou en partageant des commentaires, documents attachés et/ou revues sur ces éléments en temps réel.

On peut enregistrer dans la plateforme des données de conception de l'ouvrage, des données relatives à l'avancement du chantier, des données relatives à l'état du sous ou du sous-sol, des données relatives à l'ouvrage tel que construit et/ou des données relatives à sa maintenance ou à son exploitation.

L'invention a encore pour objet, selon un autre de ses aspects, un procédé de construction d'un ouvrage, notamment un bâtiment ou une infrastructure de surface ou souterraine, comportant les étapes consistant à :
- Télécharger à partir de la plateforme selon l'invention, des données géolocalisées relatives à l'environnement de l'ouvrage, notamment son sous-sol,
- Réaliser l'ouvrage en tenant compte des données téléchargées.

On peut avantageusement enregistrer dans la plateforme des données de conception de l'ouvrage, des données relatives à l'avancement du chantier, des données relatives à l'état du sol ou du sous-sol, des données relatives à l'ouvrage tel que construit et/ou des données relatives à sa maintenance.

L'invention pourra être mieux comprise à la lecture de la description détaillée qui va suivre, d'exemples de mise en oeuvre non limitatifs de l'invention, et à l'examen du dessin annexé, sur lequel :
- la figure 1 représente de façon schématique un exemple d'architecture matérielle de la plateforme selon l'invention,
- la figure 2 illustre de façon schématique un exemple d'architecture logicielle de la plateforme selon l'invention,
- la figure 3 représente un exemple de carte pouvant apparaître sur le navigateur de la plateforme,
- la figure 4 illustre la connexion d'un utilisateur à la plateforme,
- les figures 5 et 6 illustrent des exemples de modifications de l'affichage en fonction d'actions effectuées,
- la figure 7 illustre la possibilité d'effectuer une recherche géo-localisée,
- la figure 8 illustre l'affichage d'une carte avec des informations concernant un point d'intérêt,
- les figures 9 et 10 illustrent la possibilité d'ajout d'informations géolocalisées,
- la figue 11 illustre un exemple de commentaire d'utilisateur,

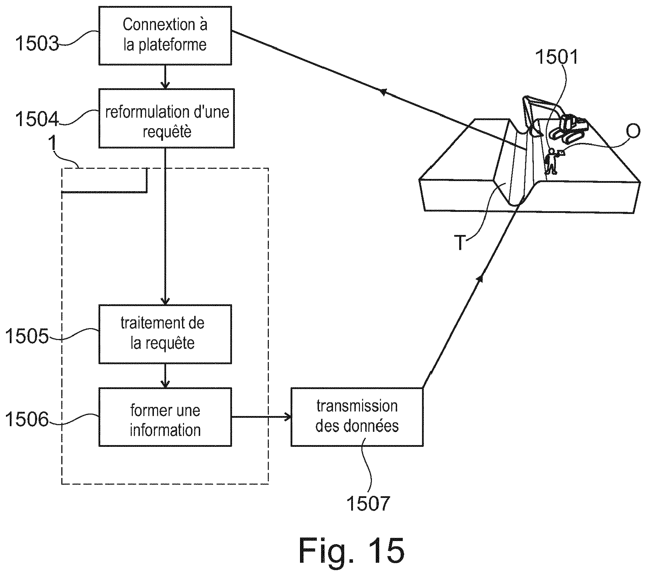

- les figures 12, 13, 14 et 15 sont des schémas en blocs illustrant différentes étapes d'exemples de procédés faisant intervenir une plateforme selon l'invention,
- les figures 16a et 16b représentent un exemple de carte illustrant un milieu urbain,
- les figures 17a et 17b représentent un exemple de carte illustrant un chantier,
- la figure 18 représente une carte avec des informations concernant des sondages,
- la figure 19 est un exemple de carte pouvant apparaître sur le navigateur de la plateforme, montrant un exemple de réseau enterré, et
- la figure 20 représente un exemple de carte illustrant une autoroute.

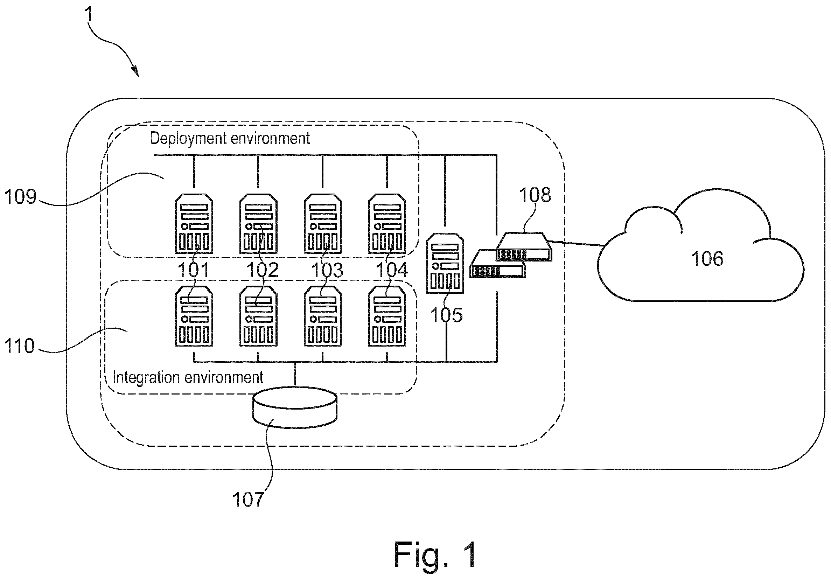

La figure 1 représente de façon schématique un exemple d'architecture physique d'une plateforme informatique 1 selon l'invention. Celle-ci comprend un ensemble de serveurs virtuels, de préférence en cloud, par exemple, comme illustré : un serveur Web 105, un ou plusieurs serveurs d'application 104, un ou plusieurs serveurs SIG 103, un ou plusieurs serveurs analytiques 102, un ou plusieurs serveurs données 101, un ou plusieurs serveurs de stockage comportant un dispositif de backup (non représenté). Ces serveurs peuvent avoir des microprocesseurs avec plusieurs coeurs, par exemple 2 ou 4 coeurs. Ces microprocesseurs peuvent être des microprocesseurs AMD, IBM, ARM ou Intel. Les serveurs peuvent avoir un système d'exploitation de type REHL notamment REHL 6.0. Ces serveurs virtuels peuvent comprendre éventuellement des agents particuliers. Chaque serveur virtuel est identifié, dans l'architecture, par au moins un identifiant serveur. Chaque serveur virtuel peut être associé à un ou plusieurs disques mémoire virtuels, par exemple de 4GB, 8GB ou 16 GB. L'utilisateur peut accéder à la plateforme 1 au travers d'un réseau 106, par exemple du type Internet, à un ou plusieurs serveurs virtuels qui lui sont dédiés parmi l'ensemble des serveurs. Cet accès est par exemple réalisé au moyen de l'identifiant du serveur virtuel dédié, et d'une clé spécifique à celui-ci. L'architecture peut comprendre également des pare-feux 108. L'architecture comprend en outre comme illustré une unité de stockage 107.

L'architecture de la plateforme 1 peut être divisée en deux environnements :
- un environnement public 109 dédié au développement et au pilotage du déploiement,
- un environnement privé 110 dédié à l'intégration et au déploiement.

Le serveur de données 102 permet de fournir et/ou recevoir des données diverses, notamment des données relatives à des objets issus de scans et des données provenant de logiciels de CAO ou DAO. Ces données peuvent être relatives à des infrastructures, bâtiments, lignes-poly lignes-polygones-textes, balises actives ou passives, barre graphe, données temps réel, fond de carte, catalogue, réseau avec noeud et arc et bibliothèque d'objets, entre autres.

Le format des données enregistrées dans la plateforme peut être un format ouvert ou propriétaire d'un certain nombre de variétés (DWG, Ascii, OBJ, vectoriel, CVS, LAS entre autres).

Le serveur de SIG 103 permet de stocker et de restituer aux utilisateurs des données SIG. Ces données peuvent être enregistrées directement sur chaque serveur SIG ou accessibles à partir de plateformes SIG tiers.

Le réseau 106 peut être n'importe quel type de réseau de communication, tel qu'un réseau local, par exemple intranet, un réseau étendu par exemple Internet ou une combinaison de ceux-ci. En variante, le réseau 7 peut être une connexion directe entre un utilisateur et la plateforme. En général, la communication entre la plateforme et un utilisateur peut être effectuée via n'importe quel type de connexion filaire et/ou sans fil, en utilisant une grande variété de protocoles de communication, par exemple, TCP / IP, HTTP, SMTP, FTP, des codages ou des formats par exemple HTML, XML, et/ou des systèmes de protection VPN, HTTP sécurisé, SSL.

Le serveur Web 105 permet d'héberger des applications Web.

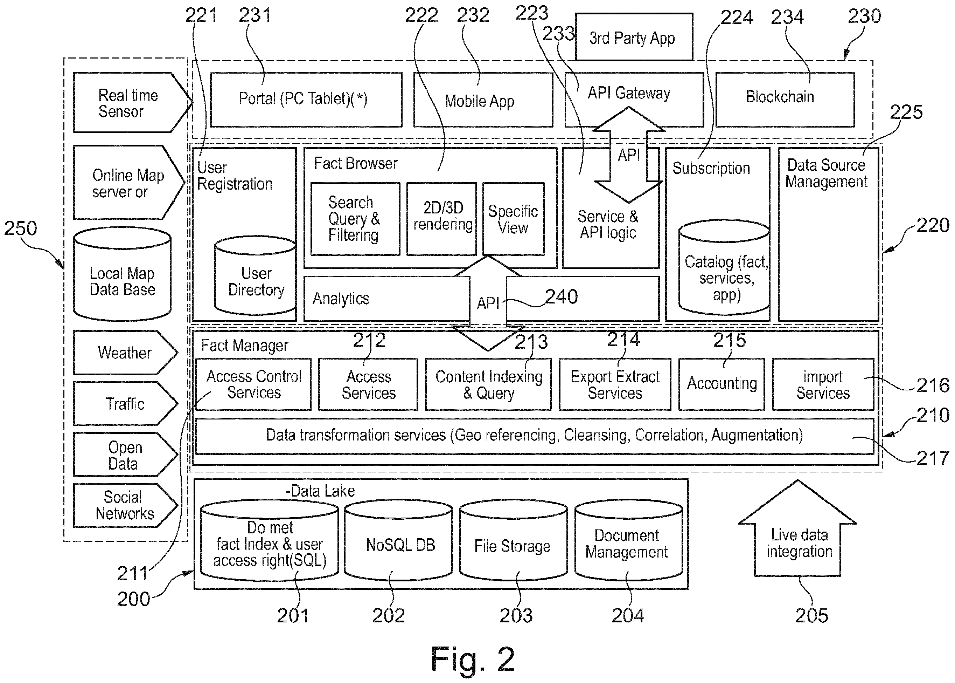

L'architecture logicielle de la plateforme est illustrée à la figure 2. Elle comporte quatre couches principales :
Une couche de stockage de données 200 permettant de stocker des données, notamment des données géo-localisées transmises par des utilisateurs à la plateforme,
une couche de gestion de données 210 permettant de contrôler l'accès à la plateforme, d'indexer les données, d'exporter ou d'importer les données,
une couche de macro-fonctions 220 fournies aux utilisateurs,
une couche d'interface 230 vers les utilisateurs.

La plateforme peut être agencée pour s'interfacer avec des fournisseurs de données externes 250, choisis notamment parmi
- Un système d'information cartographique ou serveur de cartographie,
- un serveur de données météorologiques,
- un serveur d'Open Data,
- un ou plusieurs serveurs de réseaux sociaux
- un ou plusieurs capteurs recevant en temps réels des données météorologiques, thermiques, de trafic et/ou sismiques, fissures, mouvements terrains.

La couche de stockage des données 200 de la plateforme selon l'invention peut comporter :
un lac de données 201. Celui-ci est configuré pour contenir des données structurées en provenance de bases de données relationnelles en couloir ou en colonne, des données semi-structurées telles que des CSV, des logs, des XML, des JSON, et des données non structurées telles que les emails, les documents et les PDF. Il peut également contenir des données binaires telles que des images, des fichiers audio ou des vidéos. Le lac de données 201 peut avantageusement comporter :
une base de données relationnelle 202. Cette base comprend de préférence toutes les informations structurées de la plateforme, et notamment les métadonnées qui permettent l'accès aux informations stockées dans la couche de données, notamment des données d'indexation de faits telles que des coordonnées spatio-temporelles, des groupements de faits, des hiérarchies, des mots clés, ainsi que la gestion de droits d'accès aux faits,
une base de données 203, de préférence de type noSQL, pour le stockage de données non structurées, notamment de données provenant de capteurs. Un exemple de service de base de données noSQL peut être le service Cloudant d'IBM. Ce service stocke les données sous forme de documents JSON,
un espace de stockage 204, de préférence de type serveur de fichier, pour recevoir des fichiers associés aux faits,
un espace de gestion documentaire 205, de préférence de type gestion électronique de documents, fournissant un espace de partage et d'échange d'informations aux utilisateurs.

La couche de stockage de données peut également être configurée pour permettre l'intégration directe en temps réel de sources d'informations externes à la plateforme.

La couche de gestion des données 210 interface la couche de stockage 200. Elle permet de prendre en compte l'hétérogénéité des diverses sources et typologies d'informations pour en donner une visibilité homogène au travers du concept de faits. Elle est configurée pour offrir les fonctionnalités suivantes :
un service de contrôle d'accès aux faits 211 qui permet de garantir la sécurité des données,
un service d'accès multicritère 212, de recherche et d'accès en lecture aux faits,
un service d'indexation et de requêtage 213 des données contenues dans le lac des données 2001,
un service d'extraction et d'export de faits 214 vers différents formats,
un service de comptabilisation des accès 215, pour mesurer le taux d'utilisation des API et des différents types de données,
un service d'import 216 et de mise à jour de manière massive ou unitaire ; ce service permet d'enrichir, de traduire les formats, de filtrer, de hiérarchiser, de valider et de nettoyer les données lors de l'import,
un service de transformation de données 217 ; ce service est configuré pour homogénéiser l'indexation des données, notamment en matière de référencement géospatial, pour corréler des données répondant à certains critères, notamment de proximité géographique, pour nettoyer et/ou enrichir certaines données externes.

La couche de gestion des données 210 est de préférence accessible à la couche de macro-fonctions 220 au travers d'une API 240. La couche de macro-fonctions peut comporter plusieurs composants dont :
un répertoire d'utilisateurs 221 qui permet de créer et gérer un compte utilisateur sur la plateforme. La création d'un compte utilisateur est effectuée en lien avec des éléments d'identification de base, par exemple l'adresse email ou le numéro professionnel d'identification. Le répertoire d'utilisateurs 211 permet également la gestion d'un identifiant ou d'un mot de passe oublié ainsi que la modification des éléments de profil dont le mot de passe en utilisant de préférence une fonctionnalité de serveur SMTP en ligne.
un navigateur de faits 222, qui permet aux utilisateurs de naviguer dans les faits renseignés sur la plateforme, d'accéder à des données de la plateforme depuis des applications externes à celle-ci, et de gérer des sources de données. Le navigateur permet une visualisation cartographique, de préférence de type GIS, avec un rendu 2D, 2,5D ou 3D en fonction du niveau de zoom ; le navigateur est de préférence agencé pour permettre l'affichage d'un catalogue de fonds de cartes disponibles et la sélection d'un ou plusieurs fonds de carte, et l'affichage en superposition d'au moins une partie des informations des fonds de carte sélectionnés, notamment pour permettre de changer l'ordre de superposition des fonds de carte au sein de la carte affichée et/ou d'implémenter des balises d'action ou d'information sur une carte ;
une logique API 223; cette logique permet de mettre en oeuvre des services et interfaces de programmation d'application de la plateforme ; ce composant permet de mettre en oeuvre la logique d'accès à des données de base ou enrichies, depuis des applications externes ; le navigateur de faits 222 et la logique API 223 peuvent faire appel à un composant transverse de service analytique ou cognitif permettant de fournir de la donnée enrichie, par exemple tendances, prédictions ou recommandations.
un composant souscription 224 ; il s'agit d'un service d'abonnement aux produits proposés par la plateforme ; ce composant peut utiliser plusieurs catalogues produits, notamment des annuaires de service, catalogues de données, « App store », etc ;
un composant gestion de sources de données 225 ; celui-ci permet de prendre en compte simplement et rapidement de nouvelles sources de données et de créer de nouvelles typologies de faits.

La couche de macro-fonctions peut communiquer avec la couche interface 230 au moyen d'un API 240. L'interface 230 de la plateforme peut comporter l'un au moins :
- d'une interface de type Web 231 accessible, soit depuis un PC ou une tablette fournissant l'accès à l'ensemble des fonctions de la plateforme ;
- d'une interface de type application mobile 232, utilisable depuis un smartphone ou une tablette ;
- d'une interface de type passerelle d'API 233 fournissant un accès public et sécurisé aux faits et services depuis des applications tierces ;
- d'une interface Blockchain 234 afin de sécuriser le partage et l'échange d'informations avec des clients ou des partenaires ; l'interface blockchain peut comporter un noeud blockchain, de préférence de type Hyperledger, avec lequel peuvent directement travailler clients et partenaires, ou s'interfacer avec d'autres noeuds Blockchain mis en oeuvre par des partenaires majeurs.

L'utilisateur peut, au moyen de l'interface, créer et avoir son environnement personnalisé de données facilement accessibles.

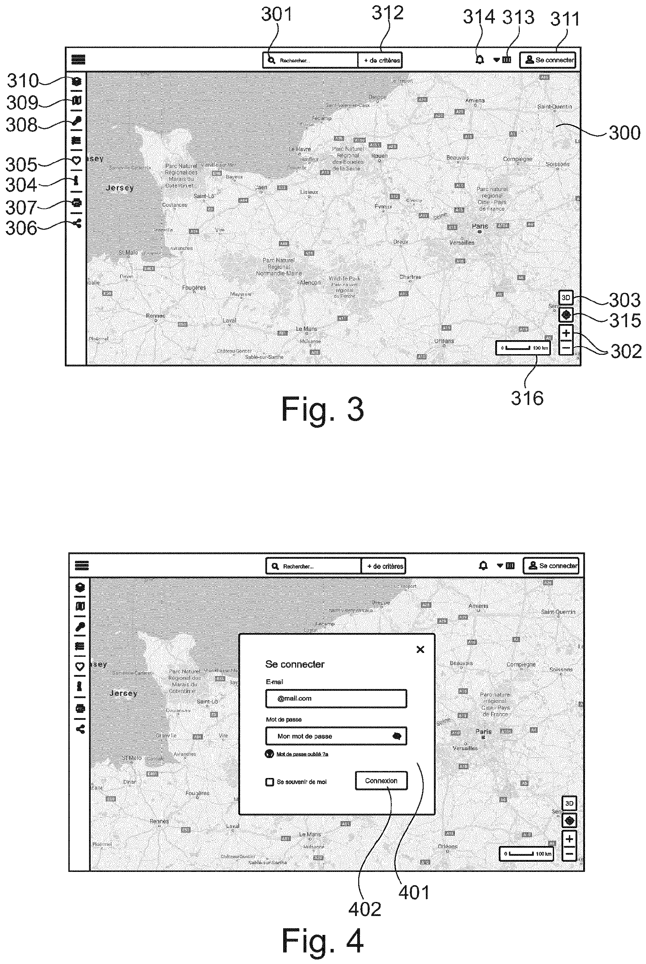

La figure 3 représente un exemple de carte pouvant apparaître sur le navigateur de la plateforme.

L'interface utilisateur peut comprendre une zone interactive d'affichage de cartes 300, une icône de partage 306 pour permettre à l'utilisateur de partager la carte sur les médias sociaux, une icône 307 pour imprimer la carte, une case de recherche 301 pour permettre à l'utilisateur d'effectuer une recherche par mots-clés, par exemple une adresse, une structure (réseau souterrain, canalisations, électricité), une pièce d'équipement (vanne, tuyau, etc.) ; cette recherche peut être personnalisée en ajoutant des critères comme par exemple le type de matériau, les dimensions, la date de construction, etc. Cette recherche personnalisée est effectuée par exemple en cliquant sur l'icône 312. L'utilisateur peut également cliquer sur un bouton d'information de caractéristiques 304, sur des informations d'échelle de carte 316, sur des sélecteurs de zoom 302, sur une icône pour activer / désactiver la géolocalisation 315, sur une icône 313 pour choisir une langue parmi une liste de langues disponibles, sur une icône 311 pour se connecter au compte utilisateur, sur une icône 314 pour créer une alerte, par exemple pour avertir l'utilisateur d'une modification, utile pour suivre un chantier ou alerter quand une information est disponible, sur une icône 310 pour permettre à l'utilisateur de choisir un fond de cartes dans un catalogue de fonds de carte disponibles, sur une icône 309 pour choisir une couche active, sur une icône 308 pour permettre à l'utilisateur de régler les paramètres de l'interface, ou sur une icône 305 pour enregistrer des points d'intérêt en tant que favoris afin de consulter plus facilement et directement les informations liées à ces sélections ultérieurement.

L'utilisateur peut interagir avec l'interface de la figure 3 en touchant par exemple l'affichage lorsque celui-ci est tactile et/ou en utilisant un pointeur de la souris pour cliquer sur les différents éléments de l'interface.

L'utilisateur peut interagir avec l'interface en faisant défiler ou en déplaçant vers le haut, le bas et / ou d'un côté à l'autre; ou en zoomant avant ou arrière. L'utilisateur peut interagir avec la carte 300, par exemple en effectuant un roulement et/ou en cliquant sur diverses caractéristiques.

La figure 4 illustre la connexion d'un utilisateur à la plateforme. Cette figure est analogue à la figure 3 sur laquelle une fenêtre supplémentaire 401 est apparue, qui permet l'identification d'un utilisateur par la saisie d'un identifiant tel qu'une adresse mail ou un numéro de téléphone par exemple, et un mot de passe.

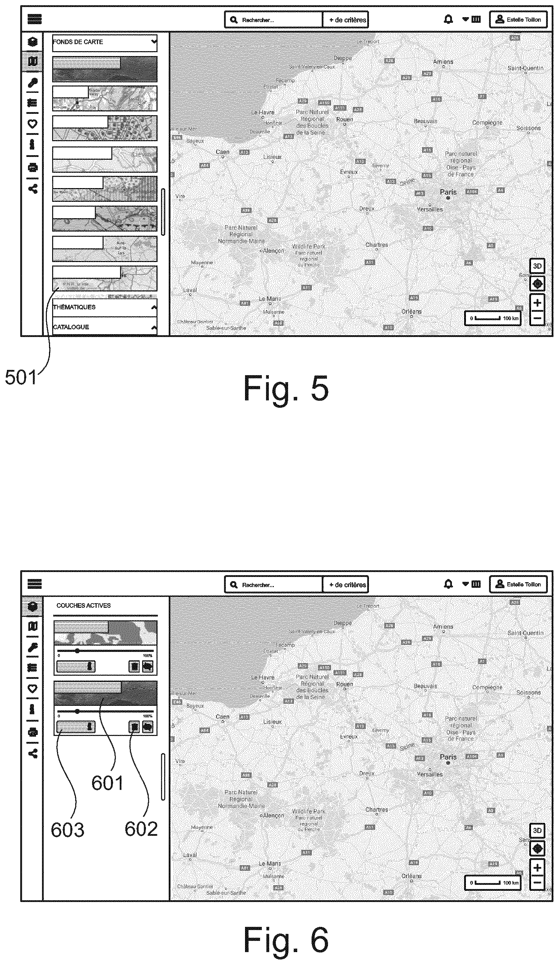

La figure 5 illustre un exemple de modification de l'affichage en fonction du fond de carte. L'utilisateur peut choisir un fond de carte parmi une liste de fond de cartes disponible dans un catalogue 501, en cliquant sur l'icône 304. Ce catalogue contient par exemple des photographies aériennes, des cartes IGN, des cartes cadastrales, des cartes France Raster, des cartes géologiques, des cartes Cassini, des cartes OpenStreetMap ou des cartes ESRI World Street Map.

La figure 6 illustre un exemple de modification de l'affichage en fonction du choix de la couche active. L'utilisateur peut accéder à un catalogue de couches actives en cliquant sur l'icône 304. Il peut choisir une couche parmi la liste disponible en cliquant sur celle-ci. L'affichage de la carte 300 change alors en conséquence.

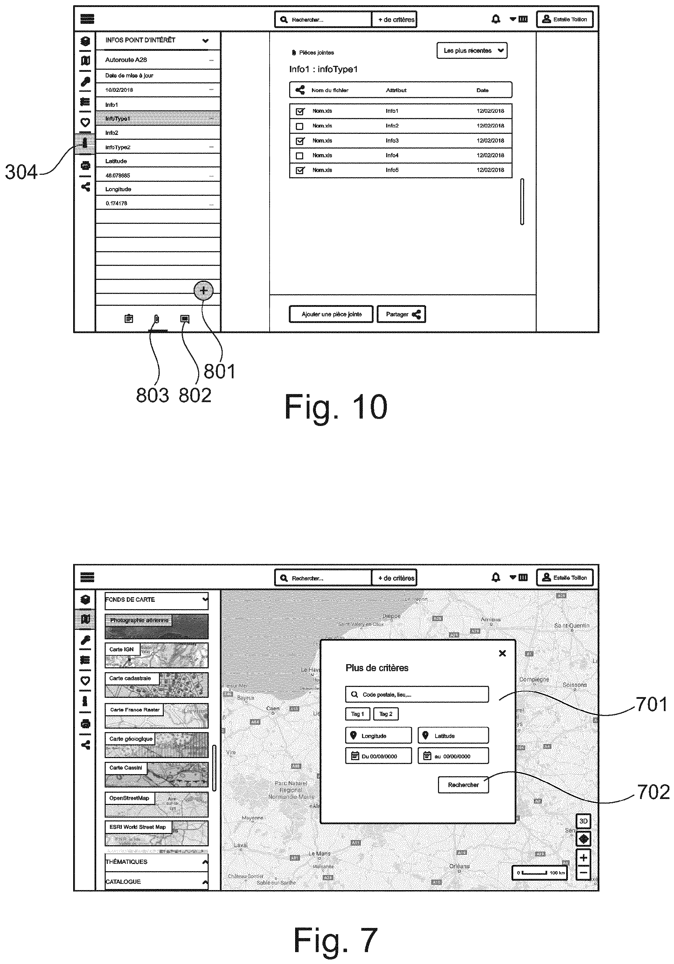

La figure 7 illustre la possibilité d'effectuer une recherche géo-localisée. La plateforme permet à l'utilisateur d'effectuer une recherche personnalisée, notamment géolocalisée en cliquant sur l'icône 304. La figure 7 montre un exemple de fenêtre 701 dédiée à la recherche personnalisée, où l'utilisateur peut saisir des informations concernant l'objet de sa recherche, notamment ses coordonnées géodésiques, longitudes et latitude. La recherche peut démarrer en cliquant sur l'icône 702.

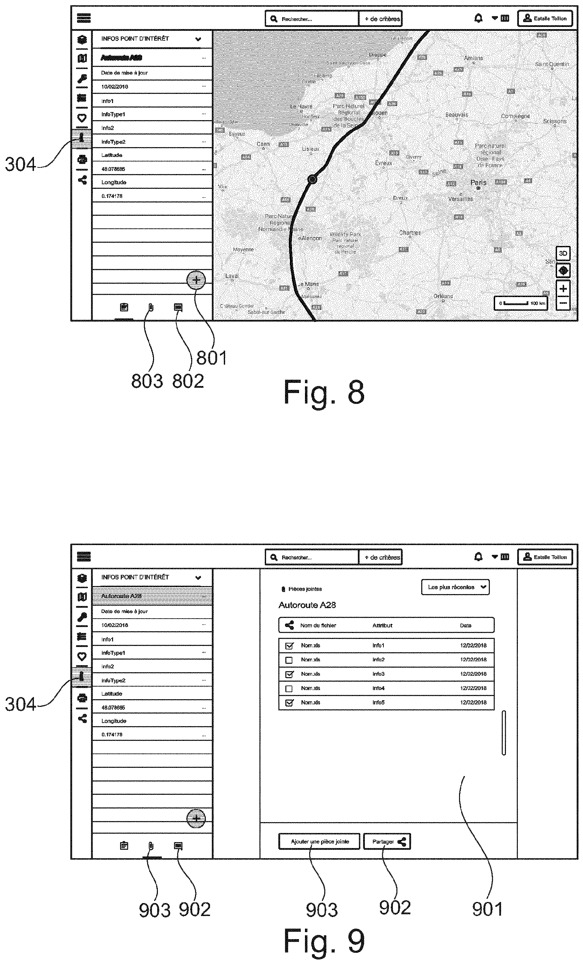

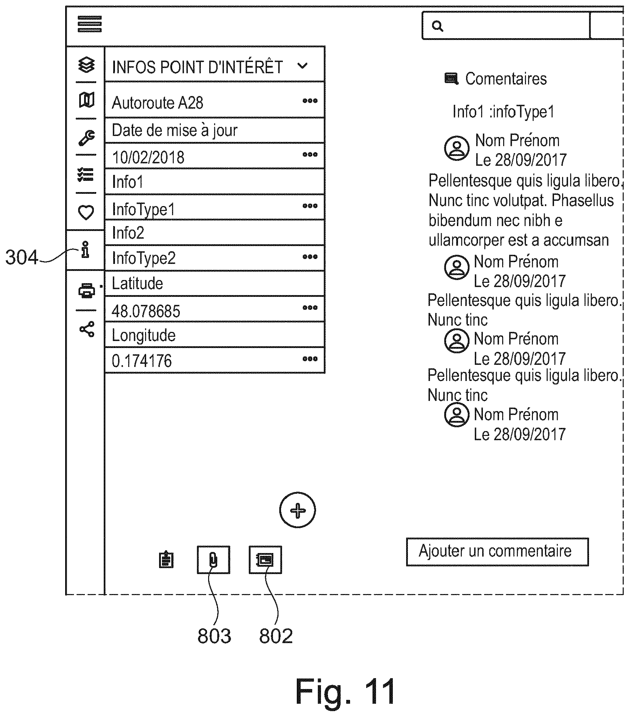

La figure 8 illustre l'affichage d'une carte avec des informations concernant un point d'intérêt. L'utilisateur peut obtenir des informations concernant un point d'intérêt en cliquant sur l'icône 304. Les informations peuvent concerner sa localisation, notamment ses coordonnées géodésiques, la précision des coordonnées, la date de mise à jour. L'utilisateur peut également ajouter des données en cliquant sur l'icône 801. L'icône 802 permet à l'utilisateur d'enregistrer des commentaires concernant le point d'intérêt. Un exemple de commentaire est illustré à la figure 11. L'utilisateur peut également ajouter des métadonnées concernant l'objet d'intérêt sous forme d'une image ou d'une vidéo par exemple.

La plateforme permet à l'utilisateur d'enregistrer des informations géolocalisées concernant un point d'intérêt ainsi qu'une information relative à la précision avec laquelle la position dans un référentiel de ces informations est connue. Les figures 9 et 10 illustrent la possibilité d'ajout d'informations géo-localisées. L'ajout de ces informations peut être réalisé en cliquant sur l'icône 902. Le format des données peut être choisi parmi DWG, Ascii, OBJ, vectoriel, CVS, LAS, entre autres possibilités.

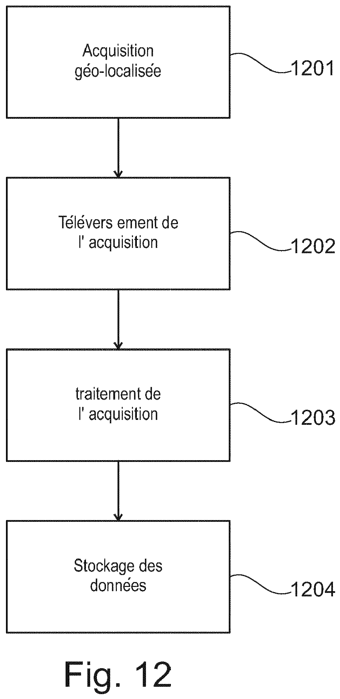

La plateforme 1 selon l'invention peut être enrichie en données géo-localisées de multiples façons, par exemple comme illustré à la figure 12 en réalisant à l'étape 1201 au moins une acquisition optique géo-localisée, de préférence un scan géo-localisé, d'un chantier ou d'un ouvrage, puis en téléversant à l'étape 1202 dans la plateforme informatique le résultat de ce scan ainsi qu'une information de géo-référencement de l'acquisition dans un référentiel. Il est intéressant de téléverser également dans la plateforme informatique une information relative à la précision avec laquelle l'information de géo-référencement est connue. L'acquisition peut être effectuée par télédétection par laser, au moyen d'au moins une caméra ou à l'aide d'un radar. Un traitement de l'acquisition peut être effectué par un outil de reconnaissance d'objets, disponible sur la plateforme informatique, à l'étape 1203. A l'étape 1204, on peut enregistrer dans la plateforme les données correspondantes, pour enrichir la plateforme de données relatives au chantier ou à l'ouvrage par des métadonnées issues de ce traitement.

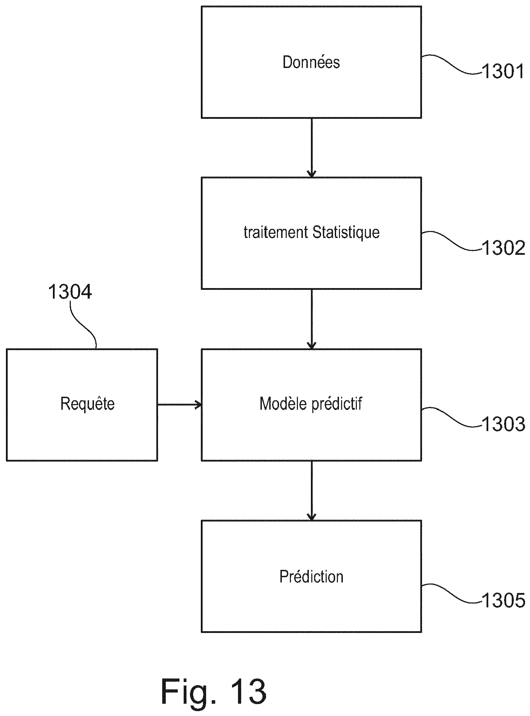

La plateforme peut également servir à déterminer au moins un modèle prédictif de la survenance d'un événement, comme illustré à la figure13. Dans ce cas, on sélectionne les données à traiter à l'étape 1301, puis on procède à un traitement 1302 statistique et/ou par intelligence artificielle, par exemple par Watson, des données sélectionnées, de façon à trouver un lien entre certains facteurs d'entrée et l'événement et générer à l'étape 1303 un modèle prédictif.

On peut ensuite à l'étape 1304 formuler une requête avec des données relatives par exemple à un chantier ou un ouvrage donné, appliquer le modèle prédictif précédemment déterminé, et obtenir à l'étape 1305 une prédiction relative aux données entrées à l'étape 1304.

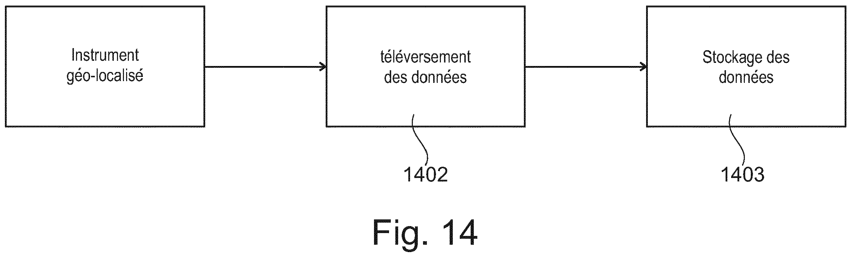

La plateforme peut permettre de suivre un chantier, en équipant comme illustré à la figure 14 une zone d'au moins un instrument géo-localisé de suivi de chantier, et en téléverser à l'étape 1402, notamment en temps réel, dans la plateforme informatique, des données issues de cet instrument. Les données résultantes peuvent être stockées à l'étape 1403 dans la plateforme.

La plateforme peut être utilisée pour réaliser une intervention dans le sous-sol, par exemple creuser une tranchée T comme illustré. Dans ce cas, l'opérateur O devant effecteur les travaux se connecte à la plateforme 1 à l'étape 1503, à l'aide d'un terminal 1501 tel qu'une tablette par exemple. Une fois la connexion effectuée, il envoie une requête concernant la nature des équipements enterrés dans la zone concernée par les travaux à l'étape 1504. La plateforme traite la requête à l'étape 1505 et génère des données à l'étape 1506, par exemple sous la forme d'une maquette 3D de la zone permettant de faire apparaître sur le terminal 1501 les réseaux enterrés avec leur position dans un référentiel ou relatif, c'est-à-dire dans le référentiel du chantier. Ensuite, ces données sont transmises à l'opérateur à l'étape 1507. L'opérateur peut réaliser l'intervention en fonction de ces données. Le cas échéant, ces données peuvent apparaître en réalité augmentée, sur un casque porté par une personne chargée de réaliser l'excavation ou sur le parebrise ou le tableau de bord de l'engin utilisé. L'opérateur peut également publier sur le chantier un dossier d'intervention en ligne sur la plateforme.

Dans cet exemple, l'opérateur tient compte lors de son intervention de la précision avec laquelle la position dans un référentiel des données géo-localisées est connue, telle que fournie par la plateforme. Ainsi, il limite le risque de toucher et dégrader un réseau enterré existant et réduit le risque d'accident physique.

Après ou au cours de l'intervention, l'opérateur peut à tout moment téléverser dans la plateforme une photographie, une vidéo ou un scan laser du chantier en cours, de façon à mettre à jour une maquette numérique du chantier, et permettre à d'autres utilisateurs d'en profiter.

La plateforme peut encore être utilisée dans le cadre de la construction d'un ouvrage, notamment un bâtiment ou une infrastructure de surface ou souterraine. Dans ce cas, les professionnels chargés de ce chantier peuvent télécharger et/ou visualiser, notamment dans un format prédéfini, à partir de la plateforme des données géo-localisées relatives à l'environnement de l'ouvrage, notamment son sous-sol. Ensuite, en fonction de ces données, et de leur mise à jour, notamment en temps réel, ils peuvent réaliser l'ouvrage. Cela permet de limiter les reprises de travaux. L'ouvrage peut être réalisé de manière coordonnée en partageant entre les différents acteurs des informations relatives à des éléments d'infrastructure à caractère géographique, telles que des informations concernant les réseaux ou bâtiments et/ou en partageant des commentaires, documents attachés et/ou revues sur ces éléments en temps réel. Les documents partagés et enregistrés dans la base peuvent notamment être des fichiers issus de logiciels de DAO ou CAO.

La plateforme peut être utilisée pour enregistrer dans celle-ci des données de conception de l'ouvrage, notamment des objets issus de logiciel de DAO ou de CAO, et des données relatives à l'avancement du chantier et à l'état du sous ou du sous-sol. Ensuite, la plateforme peut servir à y enregistrer des données relatives à l'ouvrage tel que construit, et des données relatives à sa maintenance ou à son exploitation.

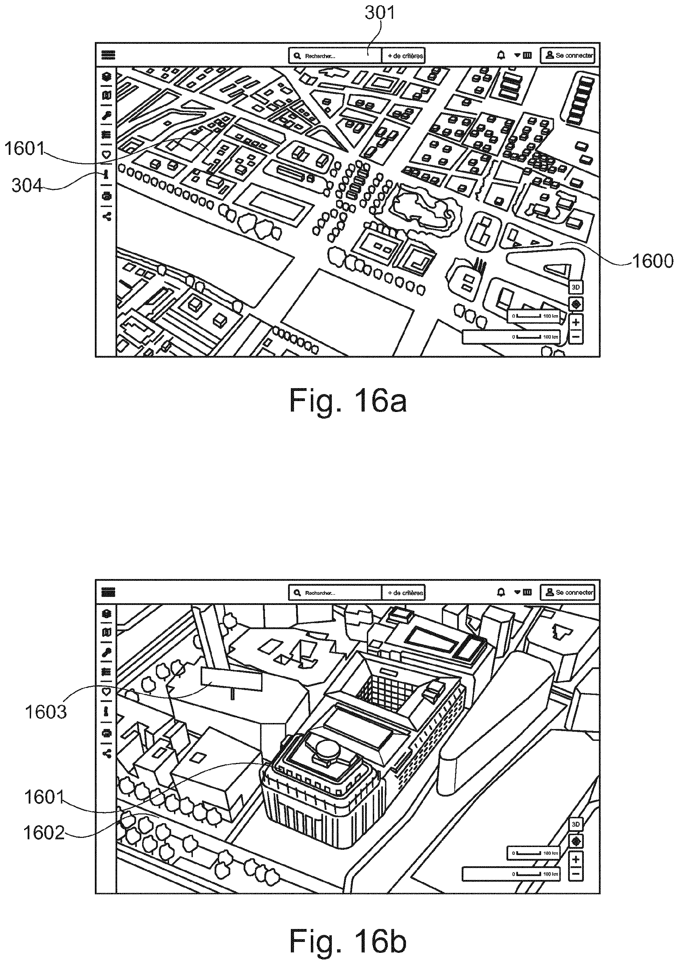

La figure 16 représente un exemple de carte illustrant un milieu urbain 1600. L'utilisateur peut accéder à cette carte en effectuant par exemple une recherche par mots-clés ou en indiquant l'adresse d'une zone urbaine d'intérêt dans la case 301. L'utilisateur peut interagir avec la carte 1600 en la faisant défiler vers l'avant ou vers l'arrière ou en déplaçant vers le haut, le bas et / ou d'un côté à l'autre; ou en zoomant avant ou arrière. Lorsque un utilisateur zoome, plus de détails apparaissent jusqu'à ce que toute la forme d'un bâtiment 1601 puisse être vue. L'utilisateur peut également interagir avec la carte 1600, par exemple en effectuant un roulement et/ou en cliquant sur diverses caractéristiques. Ainsi, l'utilisateur peut obtenir une vue souhaitée des structures, notamment des bâtiments 1601 et des rues 1602. La figure 16b montre un exemple zoomé d'un groupe de bâtiments 1601. La plateforme permet également d'afficher des caractéristiques relatives aux objets affichés, par exemple le nom des bâtiments et des rues.

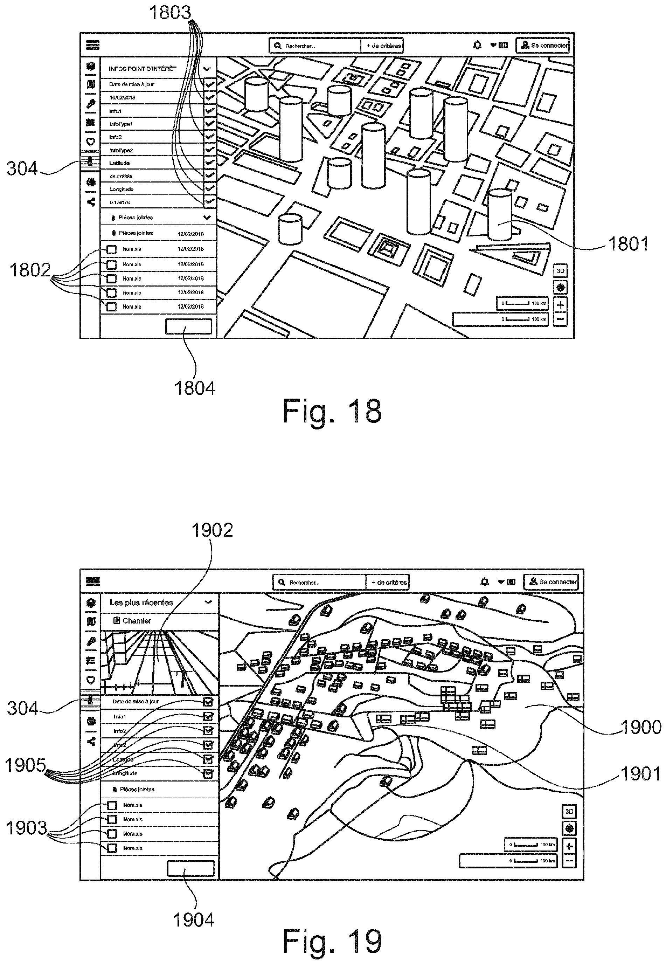

La figure 18 présente l'affichage d'une carte avec des informations concernant des résultats de sondages 1801 effectués dans la zone affichée, par exemple géotechniques, piézométriques, de pollution. L'utilisateur peut obtenir des informations relatives à ces sondages en cliquant sur l'icône 304. Les informations peuvent concerner sa localisation, notamment ses coordonnées géodésiques, la précision des coordonnées, la date de création et/ou de mise à jour, le nom de l'utilisateur ayant fourni ces informations ; des caractéristiques sur le sondage, par exemple les caractéristiques du sol, notamment mécaniques, hydriques et/ ou hydrauliques, la teneur en minerai, en hydrocarbures. La plateforme peut permettre à l'utilisateur d'accéder à un logiciel tiers permettant de générer une carte 2D et/ou 3D continue du sol ou du sous-sol à partir des données ponctuelles fournies par les sondages, par exemple un logiciel de géostatistique. L'utilisateur peut modifier ces caractéristiques en cliquant sur l'icône 1803. L'utilisateur peut également télécharger des informations en cochant sur l'icône 1802 correspondant à l'information souhaitée et en cliquant sur l'icône 1804.

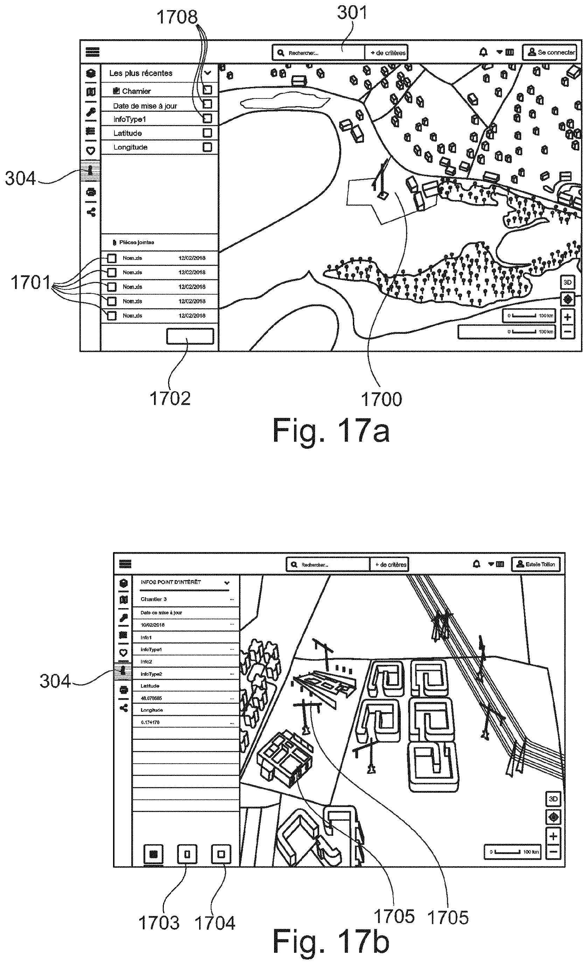

La figure 17a présente un exemple de carte illustrant un chantier 1700. L'utilisateur peut accéder à cette carte en effectuant une recherche par exemple par mots-clés ou en indiquant l'adresse du chantier dans la case de recherche 301. L'utilisateur peut ainsi avoir une visualisation globale du chantier et de ses environs. Il peut ainsi surveiller les alentours du chantier, repérer des points d'accès ou prendre en compte l'évolution du voisinage du chantier au cours de sa réalisation. L'utilisateur peut accéder à des informations relatives au chantier en cliquant sur l'icône 304; il peut également télécharger ces informations en cliquant sur l'icône 1702.

La figure 17b montre un exemple du chantier à un zoom plus élevé. L'utilisateur peut suivre l'avancement du chantier et obtenir des informations concernant des points d'intérêt 1705 de celui-ci, par exemple une construction ou un équipement (grue, vanne, tuyau). Les informations peuvent concerner la localisation du point d'intérêt, notamment ses coordonnées géodésiques et la précision de localisation correspondante. Il est également possible d'attacher un document à la plateforme en cliquant sur l'icône 1703, comme par exemple une photographie par exemple ou un rapport d'avancement de chantier. L'utilisateur peut également ajouter un commentaire en cliquant sur l'icône 1704, par exemple une remarque, une question ou répondre à une question d'un autre utilisateur. La centralisation de l'information permet ainsi aux utilisateurs d'accéder à tout moment à des informations diverses fournies par des opérateurs différents. Ainsi les utilisateurs de la plateforme gagnent en temps et en efficacité puisqu'ils ne sont plus obligés d'utiliser plusieurs plateformes ou de contacter un opérateur pour obtenir une information. Ils peuvent en effet visualiser toutes les informations relatives au chantier sur une plateforme unique.

La figure 19 est un exemple de carte pouvant apparaître sur le navigateur de la plateforme, montrant un réseau enterré, par exemple un réseau de conduites de gaz, d'électricité, de fibres optiques, de télécommunication, de canalisations de chauffage urbain, d'eau potable ou d'assainissement. L'utilisateur peut obtenir des informations sur au moins un point d'intérêt, par exemple une vanne 1901, en cliquant sur celui-ci et sur l'icône 304. Les informations peuvent concerner sa localisation, notamment ses coordonnées géodésiques, la précision des coordonnées, la date de mise à jour, une photographie 1902. L'utilisateur peut modifier au moins l'une de ces informations en cliquant sur l'icône 1905. L'utilisateur peut télécharger des informations en cochant l'icône 1903 correspondant à l'information souhaitée et en cliquant sur l'icône 1904.

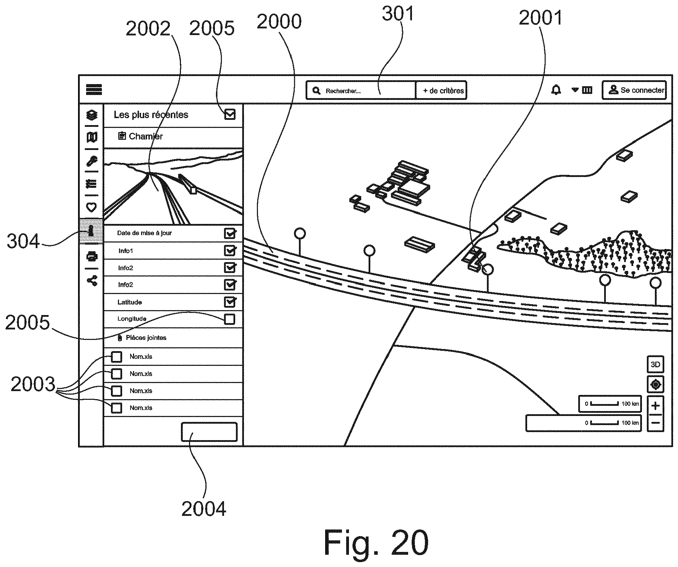

La figure 20 représente un exemple de carte illustrant une autoroute 2000 avec des informations concernant un point d'intérêt 2001. L'utilisateur peut accéder à cette infrastructure en effectuant par exemple une recherche par mots-clés dans la case 301. L'utilisateur peut obtenir des informations sur au moins l'un des points caractéristiques de l'autoroute 2001 en cliquant sur celui-ci et sur l'icône 304. Les informations peuvent concerner sa localisation, notamment ses coordonnées géodésiques, la précision de localisation, la date de mise à jour, une photographie de l'autoroute 2002. L'utilisateur peut modifier au moins l'une de ces informations en cliquant sur l'icône 2005. L'utilisateur peut télécharger ces informations en cochant l'icône 2003 correspondant à l'information souhaitée et en cliquant sur l'icône 2004.

Bien entendu, l'invention n'est pas limitée aux exemples décrits. On peut notamment modifier l'architecture matérielle et logicielle de la plateforme.

## Revendications

1. Plateforme informatique (1) pour l'agrégation et la visualisation de données numériques à l'échelle planétaire ou sub-planétaire, **caractérisée en ce que** dans celle-ci soient répertoriées des données géoréférencées servant à la représentation d'objets hétérogènes provenant de sources différentes, dont des objets issus de scans et des objets issus d'au moins un logiciel de dessin assisté par ordinateur, à au moins une partie des données géo-référencées étant associées des métadonnées enregistrées dans au moins une base de données, ces métadonnées comportant au moins une information relative à la précision avec laquelle la position dans au moins un référentiel de ces données géoréférencées est connue,
la plateforme comportant :
- une couche de stockage de données (200) permettant de stocker des données, notamment des données géo-localisées transmises par des utilisateurs à la plateforme,
- une couche de gestion de données (210) permettant de contrôler l'accès à la plateforme, d'indexer les données, d'exporter ou d'importer les données,
- une couche de macro-fonctions (220) fournies aux utilisateurs,
- une couche d'interface vers les utilisateurs (230).

2. Plateforme selon la revendication 1, au moins une partie des données enregistrées dans la base étant relative au sous-sol et/ou à des objets incorporés dans le sol.

3. Plateforme selon l'une des revendications 1 et 2, les données enregistrées dans la base de données comportant des images panoramiques, des orthophotographies, notamment des images aériennes et satellitaires, des images de type élévation, et/ou des données en nuages de points.

4. Plateforme selon l'une quelconque des revendications précédentes, les objets de scan étant modélisés en utilisant des techniques de lasergrammétrie, de photogrammétrie ou d'interférométrie.

5. Plateforme selon l'une quelconque des revendications précédentes, comportant des données géologiques du sous-sol ayant une précision de géolocalisation, dans un référentiel, meilleure que 1m et/ou étant agencée pour permettre l'enregistrement sur la plateforme de telles données.

6. Plateforme selon l'une quelconque des revendications précédentes, étant agencée pour offrir tout ou partie des fonctionnalités suivantes :
- permettre à une pluralité d'utilisateurs de se connecter à distance via des terminaux à celle-ci et pour permettre de réserver l'accès à certaines données à un groupe d'utilisateurs prédéfini, ou au contraire de mettre ces données à disposition de tous les utilisateurs,
- permettre à un utilisateur de sélectionner un objet, notamment un lieu, ouvrage et/ou équipement pour accéder à et/ou télécharger des données géo-localisées relatives à celui-ci, ces données étant délivrées par la plateforme avec une information relative à la précision avec laquelle la position de ces données géo-localisées est connue dans un référentiel,
- pour permettre à un utilisateur d'afficher une carte sur son terminal et d'attacher des documents à un objet, notamment un lieu, ouvrage, équipement ou autre objet présent sur la carte,
- permettre à un utilisateur de téléverser une application pour la mettre à disposition d'autres utilisateurs de la plateforme et leur permettre de l'exécuter au sein de la plateforme pour traiter leurs données,
- permettre à un utilisateur de partager une information avec d'autres utilisateurs de la plateforme et/ou permettre à au moins deux utilisateurs de travailler en collaboration à travers la plateforme par échanges de données entre ces utilisateurs ou via des accès multiples à une information,
- permettre à un utilisateur d'enregistrer directement ses données et/ou de les télécharger depuis une base de données tierce,
- permettre à un utilisateur de créer un profil personnalisé d'utilisateur et d'interagir avec la plateforme via une interface personnalisée,
- permettre à un utilisateur d'enregistrer dans la plateforme des données relatives à différents objets, notamment ouvrages et/ou équipements tels que construits, au moins une partie de ces données étant des données géo-localisées dans un référentiel,
- permettre à un utilisateur d'enrichir les données d'objets, notamment d'ouvrages et/ou d'équipements répertoriés dans la plateforme par des métadonnées choisies notamment parmi le nom de l'ouvrage ou de l'équipement, une caractéristique de l'ouvrage, une date, notamment de construction, et pour permettre à un utilisateur de faire des recherches multicritères sur ces éléments,
- permettre à un utilisateur ayant réalisé une intervention dans un lieu ou sur un ouvrage et/ou équipement répertorié dans la plateforme, d'enregistrer sur celle-ci un score représentatif de la fiabilité des données renseignées, notamment de la fiabilité de l'information de précision de localisation des données géo-localisées, un indice de confiance étant de préférence calculé à partir des scores renseignés par les utilisateurs précédents et fourni à chaque nouvel utilisateur cherchant à télécharger ces données,
- permettre à un utilisateur se connectant à la plateforme d'interroger celle-ci concernant l'évolution d'au moins un paramètre d'un objet, notamment d'un ouvrage et/ou d'un équipement, et d'obtenir en retour, grâce à un outil de prédiction, une prévision sur le devenir dudit paramètre, l'outil de prédiction ayant été généré en traitant des données enregistrées sur la plateforme à l'aide d'un moteur à intelligence artificielle ou par une technique d'analyse statistique, et/ou
- fournir des informations permettant de guider un engin ou d'assister un opérateur grâce à de la réalité augmentée.

7. Plateforme selon l'une quelconque des revendications précédentes, les données géo-localisées enregistrées dans celle-ci comportant des données liées à la conception, la construction et/ou l'exploitation d'un bâtiment ou d'une infrastructure de surface ou souterraine, tel qu'existant, et/ou les données géo-localisées comportant des données correspondant à des chantiers, ouvrages ou équipements respectifs éloignés de plus de 100 km.

8. Plateforme selon l'une quelconque des revendications précédentes, exécutant une application pour analyser la corrélation entre au moins deux modèles 3D relatifs à un même objet, notamment ouvrage ou équipement et générer en fonction des corrélations détectées un nouveau modèle 3D à partir de la fusion des deux modèles analysés, et/ou exécutant une application pour convertir automatiquement un format dans lequel un fichier a été téléchargé en un format prédéfini et afficher sur une même carte des informations provenant de fichiers différents dont l'un au moins a subi cette conversion, et/ou recevant, notamment en temps réel, des données météorologiques, thermiques, de trafic et/ou sismiques, et permettant à au moins un utilisateur d'accéder à et/ou de télécharger ces données.

9. Plateforme selon l'une quelconque des revendications précédentes, la couche de stockage des données (200) comportant :
- Un lac de données (201),
- une base de données relationnelle (202), comprenant de préférence toutes les informations structurées de la plateforme, et notamment les métadonnées permettant l'accès aux informations stockées dans la couche de données, notamment des données d'indexation de faits telles que des coordonnées spatio-temporelles, des groupements de faits, des hiérarchies, des mots clés, ainsi que la gestion de droits d'accès aux faits,
- une base de données (203), de préférence de type noSQL, pour le stockage de données non structurées, notamment de données provenant de capteurs,
- un espace de stockage (204), de préférence de type serveur de fichier, pour recevoir des fichiers associés aux faits, et
- un espace de gestion documentaire (205), de préférence de type gestion électronique de documents, fournissant un espace de partage et d'échange d'information aux utilisateurs.

10. Plateforme selon l'une quelconque des revendications précédentes, la couche de gestion des données (210) étant accessible à la couche de macro-fonctions (220) au travers d'une API (240) et/ou étant configurée pour offrir tout ou partie des fonctionnalités suivantes:
- Un service d'accès multicritère (212), de recherche et d'accès en lecture aux faits,
- Un service de contrôle d'accès aux faits (211), permettant de garantir la sécurité des données,
- Un service d'extraction et d'export de faits (214), vers différents formats,
- Un service de comptabilisation des accès (215), pour mesurer le taux d'utilisation des API et des différents types de données,
- Un service d'import (216) et de mise à jour de manière massive ou unitaire, permettant d'enrichir, de traduire les formats, de filtrer, de hiérarchiser, de valider et de nettoyer les données lors de l'import,
- Un service de transformation de données (217) configuré pour homogénéiser l'indexation des données, notamment en matière de référencement géospatial, pour corréler des données répondant à certains critères, notamment de proximité géographique, pour nettoyer et/ou enrichir certaines données externes.

11. Plateforme selon l'une quelconque des revendications précédentes, la couche de macro-fonctions (220) étant agencée pour réaliser tout ou partie des fonctions suivantes, et de préférence l'intégralité des fonctions suivantes :
- Création et gestion d'un compte utilisateur sur la plateforme,
- naviguer dans les faits renseignés sur la plateforme à l'aide d'un navigateur (222),
- l'accès à des données de la plateforme depuis des applications externes à celle-ci, et
- la gestion des sources de données.

12. Plateforme selon la revendication 11, le navigateur (222) étant agencé pour :
- permettre une visualisation cartographique, de préférence de type GIS, avec un rendu 2D, 2,5D ou 3D en fonction du niveau de zoom, le navigateur étant de préférence agencé pour permettre l'affichage d'un catalogue de fonds de cartes disponibles et la sélection d'un ou plusieurs fonds de carte, et l'affichage en superposition d'au moins une partie des informations des fonds de carte sélectionnés, et notamment permettre de changer l'ordre de superposition des fonds de carte au sein de la carte affichée et/ou d'implémenter des balises d'action ou d'information sur une carte,
- permettre d'afficher le déploiement d'un polygone de sélection sur une carte et/ou étant agencé pour calculer la distance entre deux points, la distance projetée, la surface d'une zone sélectionnée, la surface projetée, avec de préférence une possibilité de sélectionner la couleur et/ou la transparence de la zone sélectionnée et l'apparition de celle-ci en fonction du zoom,
- permettre d'implémenter une barre graphe et des coupes longitudinales représentant une stratigraphie du sous-sol,
- permette d'affecter et d'afficher dans un format prédéfini un attribut à un objet figurant sur la carte,
- permettre de créer un groupe d'objets et de le faire apparaître en tant que tel sur la carte,
- permettre d'afficher automatiquement des grandeurs liées aux objets apparaissant sur la carte, notamment la surface des objets, le nombre d'objets par type, le nombre de documents liés,
- permettre une recherche par coordonnées dans un référentiel,
- offrir des outils de mesure d'une distance sur la carte, d'une surface, d'éditer un profil altimétrique, de calculer une isochrone, de mesurer un azimut, et/ou de simuler un éclairage d'un site en fonction de l'heure dans la journée, et/ ou
- permettre de définir et de mémoriser un profil de recherche, notamment permettant d'afficher automatiquement des champs de recherche prédéfinis associés à un identifiant de l'utilisateur.

13. Plateforme selon l'une quelconque des revendications précédentes, la couche d'interface vers les utilisateurs (230) comportant l'un au moins :
- D'une interface de type Web (231),
- d'une interface de type application mobile (232),
- d'une interface de type passerelle d'API (233),
- d'une interface blockchain (234), notamment une interface comportant un noeud blockchain, de préférence de type Hyperledger.

14. Procédé d'enregistrement de données relatives à un chantier ou ouvrage, comportant l'étape consistant à réaliser au moins une acquisition optique géolocalisée, de préférence un scan géolocalisé, du chantier ou de l'ouvrage, et à téléverser dans la plateforme informatique selon l'une quelconque des revendications précédentes cette acquisition, ainsi qu'une information de géo-référencement de l'acquisition dans un référentiel.

15. Procédé selon la revendication 14, comportant l'étape consistant à téléverser également dans la plateforme informatique une information relative à la précision avec laquelle l'information de géo-référencement est connue, l'acquisition étant notamment effectuée par télédétection par laser ou au moyen d'au moins une caméra, le procédé comportant de préférence, un traitement de l'acquisition par un outil de reconnaissance d'objets disponible sur la plateforme informatique et l'enrichissement de données relatives au chantier ou à l'ouvrage par des métadonnées issues de ce traitement.

16. Procédé pour déterminer au moins un modèle prédictif de la survenance d'un événement, comportant un traitement statistique et/ou par intelligence artificielle de données enregistrées sur la plateforme selon l'une quelconque des revendications 1 à 13 de façon à trouver un lien entre certains facteurs d'entrée et l'événement et générer ledit modèle prédictif.

17. Procédé de suivi de chantier, comportant l'étape consistant à équiper une zone d'au moins un instrument géo-localisé de suivi de chantier et à télécharger, notamment en temps réel, dans la plateforme informatique selon l'une quelconque des revendications 1 à 13, des données issues de cet instrument.

18. Procédé pour réaliser une intervention, notamment en sous-sol comportant notamment le creusement d'une excavation et/ou la réalisation d'un forage, le procédé comportant les étapes consistant à :
- Se connecter à la plateforme selon l'une quelconque des revendications 1 à 13, et télécharger des données géo-localisées relatives à un lieu et/ou ouvrage concerné par l'intervention,
- réaliser l'intervention en fonction de ces données, et de préférence publier sur le chantier un dossier d'intervention en ligne sur la plateforme, l'intervention étant réalisée de préférence en fonction de la précision avec laquelle la position dans un référentiel des données géolocalisées est connue, telle que fournie par la plateforme, permettant notamment de limiter le risque de toucher et dégrader un réseau enterré existant et ainsi de limiter le risque d'accident physique.

19. Procédé de construction d'un ouvrage, notamment un bâtiment ou une infrastructure de surface ou souterraine, comportant les étapes consistant à :
- Télécharger et/ou visualiser, notamment dans un format prédéfini, à partir de la plateforme selon l'une quelconque des revendications 1 à 13, des données géolocalisées relatives à l'environnement de l'ouvrage, notamment son sous-sol,
- réaliser l'ouvrage en tenant compte des données téléchargées et de leur mise à jour, notamment en temps réel, permettant de limiter les reprises de travaux, et de préférence en réalisant l'ouvrage de manière coordonnée en partageant entre les différents acteurs des informations relatives à des éléments d'infrastructure à caractère géographique telles que des informations concernant les réseaux ou bâtiments et/ou en partageant des commentaires, documents attachés et/ou revues sur ces éléments en temps réel, et/ou
- enregistrer dans la plateforme des données de conception de l'ouvrage, des données relatives à l'avancement du chantier, des données relatives à l'état du sol ou du sous-sol, des données relatives à l'ouvrage tel que construit et/ou des données relatives à sa maintenance ou à son exploitation.
